# EUROPEAN PATENT SPECIFICATION

(11) **EP 0 403 220 B1**
(45) Date of publication and mention of the grant of the patent: **14.09.1994**
(21) Application number: 90306376.6
(22) Date of filing: 12.06.1990
(51) Int. Cl.: G03F 7/00, G03F 9/00, G03F 1/08, H01L 21/308

(54) **Producing exposure masks**
Herstellung von Belichtungsmasken
Production de masques d'exposition

(30) Priority: 13.06.1989 JP 150289/89
(43) Date of publication of application: 19.12.1990
(73) Proprietor: SONY CORPORATION, Tokyo 141 (JP)
(72) Inventor: Kawahira, Hiroichi, C/o Patents Division, Shinagawa-ku, Tokyo 141 (JP); Gunji, Takehiko, C/o Patents Division, Shinagawa-ku, Tokyo 141 (JP); Nozawa, Satoru, C/o Patents Division, Shinagawa-ku, Tokyo 141 (JP)
(74) Representative: Cotter, Ivan John

(56) References cited:
- EP-A- 0 121 412
- GB-A- 2 066 487

## Description

This invention relates to producing exposure masks, and more particularly to producing an exposure mask wherein exposure processing and selective etching processing of a mask film formed on a transparent substrate are performed to form a mask pattern of the mask film.

When semiconductor integrated circuits (ICs) such as large scale integrated circuits (LSIs) or very large scale integrated circuits (VLSIs) are to be produced, it is necessary to form various patterns on semiconductor substrates. The formation of patterns is performed by an optical transfer method, according to which a mask wherein a mask film is selectively formed on a transparent substrate is prepared in advance, and then light, an ion beam, an electron beam or the like is projected on to a semiconductor substrate by way of the mask. Such a method is disclosed, for example, in Japanese Patent Application publication No. JP-A-59 178 726.

More particularly, a photo-resist film of negative type or positive type is first applied to a surface of a semiconductor substrate, after which light, an ion beam, an electron beam or the like is projected on to the photo-resist film by way of an exposure mask. Then, in the case when the photo-resist film is of the negative type, a portion of the photo-resist film which is irradiated (for example with light) is cured, whereas, in the case when the photo-resist is of the positive type, a portion of the photo-resist film which is irradiated (for example with light) is resolved. After this, development processing is performed. Consequently, in the case when the photo-resist film is of the negative type, a remaining portion of the photo-resist film other than the portion which has been cured by irradiation (for example with light) is removed, whereas in toe case when the photo-resist film is of the positive type the portion of the photo-resist film which has been irradiated (for example with light) is removed while the remaining portion (which has not been irradiated, for example with light) remains as it is. After such development, a predetermined pattern is formed on the semiconductor substrate by etching of a ground film and so forth using the photo-resist film as a mask. Further, introduction of impurities may sometimes be performed using the photo-resist film as a mask.

In fabricating an IC, formation of a pattern on the semiconductor substrate is performed several times and, in carrying out each such pattern formation, a photo-resist film of the negative type or a photo-resist film of the positive type may be used, but all of the patterns cannot be formed using photo-resist films only of either one of the two types. This is because, if the ratio of the area of a portion to be etched to the entire area of the semiconductor substrate is very low, such as when a through-hole is to be formed in an insulator film, fine formation can be performed comparatively readily only if a photo-resist film of the positive type is used, whereas, on the contrary, if the ratio of the area of a portion to be etched to the entire area of the semiconductor substrate is comparatively high, it is preferable to use a photo-resist film of the negative type. Besides, in a process for producing a semiconductor device, it is necessary to form a pattern wherein a portion to be etched is greater in area than the other portion which is not to be etched, and also it is necessary to form another pattern wherein the relationship is reversed.

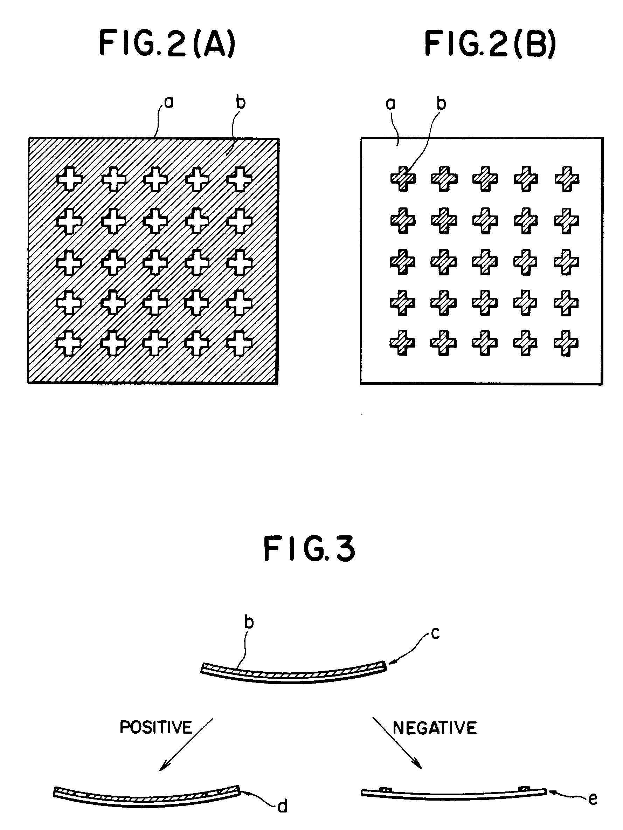

Figure 2(A) of the accompanying drawings shows a negative reticule which is applied as an exposure mask for use in etching using a photo-resist film of the positive type, and Figure 2(B) shows a positive reticule which is applied as an exposure mask for use in etching using a photo-resist film of the negative type.

The positive and negative reticules shown in Figures 2(A) and 2(B) each include a transparent substrate a made of glass and a mask film b formed on one of the two opposite main surfaces of the transparent substrate a, the mask film commonly being made of chrome. The negative reticule shown in Figure 2(A) is normally produced in the following manner. FIrst, a mask film b of chrome or the like is formed on an entire main surface of a transparent substrate a, and a photo-resist film of the positive type is then formed on the mask film b and then exposed to irradiation, such as light, for instance by using an electron beam exposing device. THen, the photo-resist film of the positive type is developed, after which the mask film b is etched using the photo-resist film of the positive type as a mask. In this instance, the ratio of the area of the remaining mask film b to the area of the entire reticule, that is the proportion of the entire area occupied by the mask film b after etching, is considerably greater than 50%. On the other hand, the positive reticule shown in Figure 2(B) is produced using a photo-resist film of the negative type as a resist film and is different in that the ratio of the area of the mask film b remaining on the transparent substrate 1 after selective etching to the entire area of the reticule, that is the proportion of the entire area occupied by the mask film b after etching, is considerably less than 50%. Conventionally, however, such positive and negative reticules are produced by the same process.

As the scale of integration of semiconductor devices increases, a progressively more urgent need arises to increase the accuracy of registration of layers formed by chip pattern transfer. Therefore, a need arises to improve the accuracy in registration between individual reticules used for the production of a device. However, it has in practice been found difficult to satisfy this requirement.

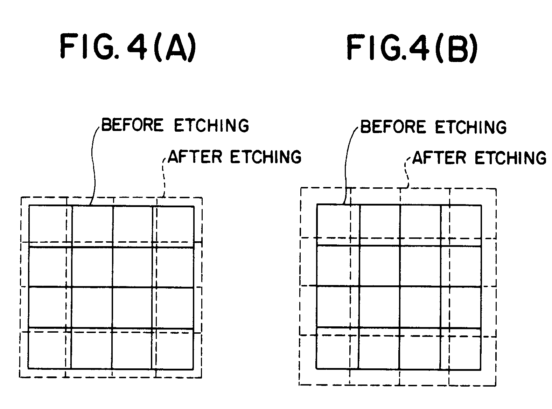

An investigation of the cause of the difficulty has been conducted. The investigation showed that the accuracy in position is different as between a reticule wherein the ratio of the area of the mask film b to the entire area of the reticule is comparatively high, as in the case of the reticule shown in Figure 2(A), and another reticule wherein the ratio of the area of the mask film b to the entire area of the reticule is comparatively low, as in the case of the reticule shown in Figure 2(B). As a result, an error in registration takes place between a layer, a film, a through-hole or the like formed using a negative reticule such as that shown in Figure 2(A), and a layer, a film, a through-hole or the like formed using a positive reticule such as that shown in Figure 2(B), thereby significantly obstructing higher scale integration of semiconductor devices. Further, it has been determined that the difference in accuracy in position between a positive reticule and a negative reticule arises from the fact that they are warped differently by thermal stress. This will now be described in more detail with reference to Figures 3 and 4 of the accompanying drawings.

At a stage before a mask pattern is formed, after a mask film b made of chrome has been formed, for example by vapour deposition, on an entire surface of a transparent substrate a made of glass, the exposure mask has some warp arising from thermal stress as shown at c in Figure 3. (For the sake of ease of explanation, the warp is shown in a somewhat exaggerated manner in Figure 3). Photo-etching of the mask film b of the exposure mask c is then performed to form a negative reticule, for example such as shown at d in Figure 3, or a positive reticule, for example such as shown at e in Figure 3. In this instance, since the area of the mask film b is reduced upon such photo etching, the warp caused by thermal stress also is reduced. However, the degree of reduction of such warp by thermal stress is different as between the positive reticule and the negative reticule. Specifically, the degree of reduction of the warp of the positive reticule, in which the area of the mask film b is comparatively small, is greater than that of the negative reticule, in which the relationship is the reverse. As a result, the degree of displacement in position coordinates which is caused by reduction of the warp is smaller with the negative reticule that with the positive reticule, as can be seen from Figures 4(A) and 4(B) of the accompanying drawings, which show the displacements for negative and positive reticules, respectively. More particularly, in Figures 4(A) and 4(B), solid lines indicate ideal gratings, while broken lines indicate actual gratings after etching, and the displacement between the gratings is a displacement of coordinates caused by the warp. If reticules having substantially the same value of the ratio of the area of the mask film b to the entire area of the reticule could be used at all mask pattern formation steps, then the tolerance in registration of layers as described above could be reduced to a very small value. In practice, however, it is impossible to perform formation of all mask patterns using reticules in all of which the ratios of the area of the mask film b to the entire area of the reticule is substantially the same. In fact, it is not possible to avoid a situation in which the ratio of the area of the mask film b to the entire area of the reticule is different for each mask pattern forming step. Accordingly, there is a great limitation to improvement of the layer registration accuracy.

According to a first aspect of the invention there is provided a process for producing an exposure mask wherein a mask film is formed on a transparent substrate, after which exposure processing and selective etching processing of the mask film are performed to form a mask pattern of the mask film, the method comprising correcting, upon exposure of the mask film for the formation of the mask pattern, the position of the mask pattern by a different correction amount in accordance with the ratio of the area of the mask film which is to remain after etching to the area of the transparent substrate.

With the above process, since the position of a mask pattern is corrected by a different correction amount in accordance with the ratio of the area of the mask film which is to remain after etching to the area of the transparent substrate, a difference between coordinates of positions on the mask which may arise from a difference between ratios of areas of the mask film to the area of the transparent substrate, that is between proportions of the entire area occupied by the mask film after etching, can be eliminated or at least reduced. Consequently, the accuracy of the mask pattern of the mask film may be improved. Thus, registration accuracy in production of semiconductor devices using such exposure masks can be improved.

According to a second aspect of the invention there is provided apparatus for the exposure of a transparent substrate having a mask film formed thereon, the apparatus comprising means for supporting thereon a transparent substrate on which a mask film is formed, an electron gun, storage means for storing therein data for the formation of a mask pattern on the mask film on the transparent substrate, means for controlling an electron beam emitted from the electron gun in accordance with data received form the storage means, and means for correcting the data stored in the storage means by a different correction amount in accordance with a ratio of the area of the mask film which is to remain after an etching operation to the entire area of the transparent substrate.

The invention will now be further described, by way of illustrative and non-limiting example, with reference to the accompanying drawings, in which like items are denoted by like references throughout, and in which:
Figure 1 is a schematic diagram of an electron beam exposure device for use in a process embodying the invention for producing an exposure mask;
Figures 2(A) and 2(B) are plan views of exposure masks or reticules of negative type and positive type, respectively;
Figure 3 is a sectional view illustration warping of exposure masks of the different types caused by photo etching; and
Figure 4(A) and 4(B) are diagrammatic representations illustrating different displacements in positional coordinates between exposure masks of the negative type and the positive type, respectively.

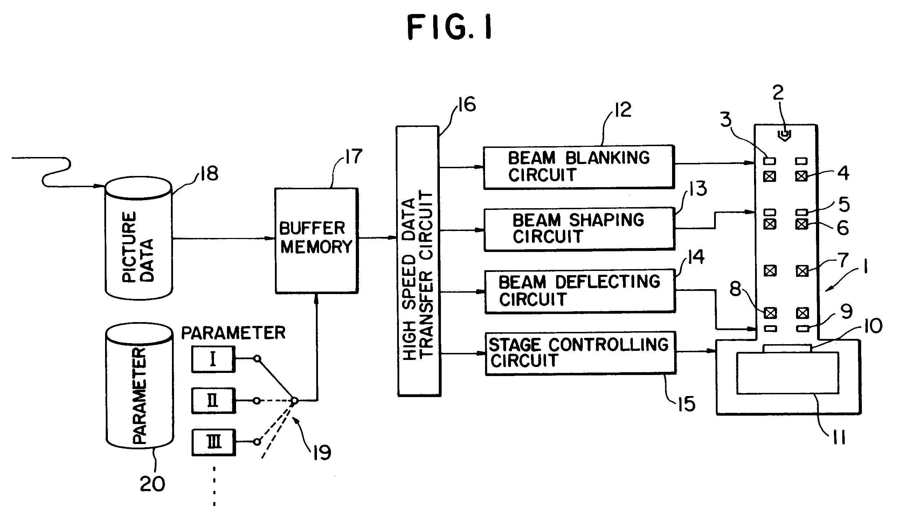

Figure 1 shows an electron beam exposure apparatus for use in exposure in the formation of a mask pattern. The illustrated electron beam exposure apparatus includes a body 1, an electron gun 2 for producing an electron beam, a blanking electrode 3, a lens 4, a beam shaping electrode 6, several lenses 7 and 8, a deflecting electrode 9, and a reticule supporting table 11 for supporting thereon a reticule 10 to be exposed to the electron beam.

The electron beam exposure apparatus further includes a beam blanking circuit 12 for performing blanking control to blank or not to blank the electron beam, a beam shaping circuit 13 for shaping the sectional shape of the beam into a predetermined shape, a beam deflecting circuit 14 for deflecting the beam, a stage controlling circuit 15, a high speed data transfer circuit 16, a buffer memory 17, and a switch 19 for causing correction of position coordinates to be performed correctly in accordance with a drawing picture ratio of a reticule (that is, the ratio of the area of a mask film to the entire area of a reticule after etching) on which a mask pattern is to be formed by exposure to radiation. Thus, data 18 in which a drawing picture ratio is employed as a parameter can be inputted in a changed over condition to the buffer memory 17. It is to be noted that the individual circuits described above are all controlled by a central processing unit (CPU) that is not shown.

In operation, after drawing picture data 18 in accordance with which a mask pattern to be formed is to be drawn are inputted, the electron beam exposure apparatus corrects the drawing picture data 18 for a displacement of position coordinates which is caused by warping of the exposure mask as described in detail above, and the electron beam exposure apparatus then draws a picture with the electron beam in accordance with the corrected drawing picture data. The correction is carried out in that a correct correction amount is always ensured by changing over the switch 19 in accordance with the drawing picture ratio of a reticule.

Data 20 for different such corrections are prepared in the following manner in advance.

First, an expansion error Xg in an X direction, another expansion error Yg in a Y direction perpendicular to the X direction, and an error Og in orthogonality of a mask pattern when an exposure mask is formed after exposure without correction, are measured. Such measurements are made for each of a reticule having a drawing picture ratio of greater than 50% (positive reticule) and another reticule having a drawing picture ratio of less than 50% (negative reticule). Here, an expansion error in the X direction with regard to a positive reticule is represented by Xgp, an expansion error in the Y direction by Ygp, and an error in orthogonality by Ogp, while an expansion error in the X direction with regard to a negative reticule is represented by Xgn, an expansion error in the 1 direction by Ygn, and an error in orthogonality by Ogn.

Then, if a reticule on which a mask pattern is to be formed is a positive reticule, the switch 19 is changed over to a positive reticule position so that data for which a correction of -Xgp has been made for the X direction, -Ygp for the 1 direction and -Ogp for the orthogonality may be read out from the buffer memory 17. Consequently, if the exposure mask has such a warp as described hereinabove, no error in position coordinates of the mask pattern takes place.

On the other hand, in the case of a negative reticule, the switch 19 is changed over to a negative reticule position and data for which a correction of -Xgn has been made for the X direction, -Ygn for the Y direction and -Ogn for the orthogonality are read out from the buffer memory 17. Consequently, in this instance also, no error of position coordinates of a mask pattern takes place.

Thus, if the switch 19 is changed over in accordance with a drawing picture ratio to correct position coordinates corresponding to the drawing picture ratio for all of the reticules necessary for the production of a semiconductor device using the apparatus shown in Figure 1 and an exposure operation then is performed, the accuracy in registration of layers can be increased greatly, and it is possible to cope with a rule of 0.35 micrometres or even with a finer rule, and also to produce 16 megabit static RAMs and 64 megabit static RAMs.

It is to be noted that changing over in accordance with the drawing picture ratio is described, by way of example, as being performed between two stages in the embodiment described above. However, in order to perform such correction more accurately, the drawing picture ratio should in general be changed over between more stages.

## Claims

1. A process for producing an exposure mask wherein a mask film (b) is formed on a transparent substrate (a), after which exposure processing and selective etching processing of the mask film (b) are performed to form a mask pattern of the mask film, the method comprising correcting, upon exposure of the mask film (b) for the formation of the mask pattern, the position of the mask pattern by a different correction amount in accordance with the ratio of the area of the mask film which is to remain after etching to the area of the transparent substrate.

2. A process according to claim 1, wherein a plurality of correction amounts are prepared in advance for each of a plurality of different types of mask film, and the amount of correction of the position of a mask pattern is selected from among such correction amounts in response to the type of mask film concerned.

3. A process according to claim 1 or claim 2, wherein the amount of correction of the position of a mask film includes expansion errors in particular perpendicular directions and an error in orthogonality.

4. Apparatus for the exposure of a transparent substrate having a mask film formed thereon, the apparatus comprising means (10) for supporting thereon a transparent substrate (a) on which a mask film (b) is formed, an electron gun (2), storage means (17) for storing therein data for the formation of a mask pattern on the mask film on the transparent substrate, means (12 to 16) for controlling an electron beam emitted from the electron gun (2) in accordance with data received form the storage means (17), and means for correcting the data stored in the storage means (17) by a different correction amount in accordance with a ratio of the area of the mask film which is to remain after an etching operation to the entire area of the transparent substrate.

5. Apparatus according to claim 4, which comprises a switch means (19), and wherein the storage means (17) has a plurality of correction amounts stored therein each appropriate to one of a plurality of different types of mask film, one of the correction amounts being selected in response to an output of the switch means (19).

## Patentansprüche

1. Verfahren zur Herstellung einer Belichtungsmaske, bei dem ein Maskenfilm (b) auf einem transparenten Substrat (a) ausgebildet und dieser Maskenfilm anschließend belichtet und selektiv geätzt wird, um aus dem Maskenfilm ein Maskenmuster zu bilden, wobei das Verfahren die Maßnahme umfaßt, daß bei der Belichtung des Maskenfilms (b) zur Erzeugung des Maskenmusters die Position des Maskenmusters nach Maßgabe des Verhältnisses der Fläche des Maskenfilms, die nach dem Ätzen verbleiben soll, zu der Fläche des transparenten Substrats durch eine individuelle Korrekturgröße korrigiert wird.

2. Verfahren nach Anspruch 1, bei dem zuvor für jeden aus einer Mehrzahl von unterschiedlichen Maskenfilmtypen eine Mehrzahl von Korrekturgrößen bereitgestellt und aus diesen Korrekturgrößen die Korrekturgröße zum Korrigieren der Position eines Maskenmusters in Abhängigkeit von dem betreffenden Maskenfilmtyp ausgewählt wird.

3. Verfahren nach Anspruch 1 oder 2, bei dem die Korrekturgröße zum Korrigieren der Position eines Maskenfilms Ausdehnungsfehler in bestimmten lotrechten Richtungen sowie einen Orthogonalitätsfehler beinhaltet.

4. Vorrichtung zum Belichten eines transparenten Substrats, auf dem ein Maskenfilm ausgebildet ist, wobei die Vorrichtung aufweist:
Mittel (10) zur Halterung eines transparenten Substrats (a), auf dem ein Maskenfilm (b) ausgebildet ist,
eine Elektronenkanone (2),
eine Speichereinrichtung (17) zur Speicherung von Daten für die Erzeugung eines Maskenmusters auf dem auf dem transparenten Substrat angeordneten Maskenfilm,
Mittel (12 bis 16) zur Steuerung eines von der Elektronenkanone (2) emittierten Elektronenstrahls nach Maßgabe von aus der Speichereinrichtung (17) empfangenen Daten sowie
Mittel zum Korrigieren der in der Speichereinrichtung (17) gespeicherten Daten durch eine individuelle Korrekturgröße nach Maßgabe des Verhältnisses der Fläche des Maskenfilms, die nach einem Ätzvorgang verbleiben soll, zu der Fläche des transparenten Substrats.

5. Vorrichtung nach Anspruch 4 mit einer Schalteinrichtung (19), wobei in der Speichereinrichtung (17) eine Mehrzahl von Korrekturgrößen gespeichert sind, die sich jeweils für einen aus einer Mehrzahl von unterschiedlichen Typen von Maskenfilmen eignen und von denen eine in Abhängigkeit von dem Ausgangssignal der Schalteinrichtung ausgewählt wird.

## Revendications

1. Procédé pour fabriquer un masque d'exposition dans lequel on forme un film de masque (b) sur un substrat transparent (a), après quoi on exécute une opération d'exposition et une opération d'incision sélective du film de masque (b) pour former un dessin de masque du film de masque, le procédé consistant à corriger la position du dessin du masque, lors de l'exposition du film de masque (b) pour la formation du dessin du masque, d'une quantité différente de correction selon le rapport de la surface du film de masque devant rester après incision à la surface du substrat transparent.

2. Procédé selon la revendication 1, dans lequel on prépare d'avance une pluralité de quantités de correction pour chacun d'une pluralité de types différents de film de masque, et on sélectionne la quantité de correction de la position d'un dessin de masque parmi ces quantités de correction en réponse au type de film de masque concerné.

3. Procédé selon l'une quelconque des revendications 1 et 2, dans lequel la quantité de correction de la position d'un film de masque inclut des erreurs de dilatation dans des directions perpendiculaires particulières et une erreur d'orthogonalité.

4. Appareil pour l'exposition d'un substrat transparent sur lequel est formé un film de masque, l'appareil comprenant un moyen (10) pour y supporter un substrat transparent (a) sur lequel est formé un film de masque (b), un canon à électrons (2), un moyen de mémorisation (17) pour y mémoriser des données pour la formation d'un dessin de masque sur le film de masque formé sur le substrat transparent, un moyen (12 à 16) pour commander un faisceau électronique émis par le canon à électrons (2) selon les données reçues du moyen de mémorisation (17), et un moyen pour corriger les données mémorisées dans le moyen de mémorisation (17) d'une quantité différente de correction selon le rapport de la surface du film de masque devant rester après une opération d'incision à toute la surface du substrat transparent.

5. Appareil selon la revendication 4, qui comprend un moyen commutateur (19), et dans lequel le moyen de mémorisation (17) comporte une pluralité de quantités de correction qui y sont mémorisées dont chacune est appropriée à un d'une pluralité de types différents de film de masque, une des quantités de correction étant sélectionnée en réponse à un signal de sortie du moyen commutateur (19).
